# EUROPEAN PATENT SPECIFICATION

(11) **EP 3 179 627 B1**
(45) Date of publication and mention of the grant of the patent: **15.04.2020**
(21) Application number: 16202092.9
(22) Date of filing: 05.12.2016
(51) Int. Cl.: H02S 40/34

(54) **PHOTOVOLTAIC JUNCTION BOX**
PHOTOVOLTAIKANSCHLUSSKASTEN
BOITE DE RACCORDEMENT PHOTOVOLTAÏQUE

(30) Priority: 08.12.2015 CN 201521011422 U
(43) Date of publication of application: 14.06.2017
(73) Proprietor: Tyco Electronics (Shanghai) Co., Ltd., Pilot Free Trade Zone Shanghai (CN)
(72) Inventor: LV, Wenbo, Shanghai, Shanghai (CN); LI, Cui, Shanghai, Shanghai (CN); XU, Xiang, Shanghai, Shanghai (CN)
(74) Representative: Grünecker Patent- und Rechtsanwälte PartG mbB

(56) References cited:
- WO-A1-2006/067907
- US-A1- 2003 193 322
- US-A1- 2011 121 441
- US-A1- 2012 052 719

## Description

### BACKGROUND OF THE INVENTION

### Field of the Invention

The present disclosure relates to a photovoltaic junction box to be mounted on a solar panel and a diode.

### Description of the Related Art

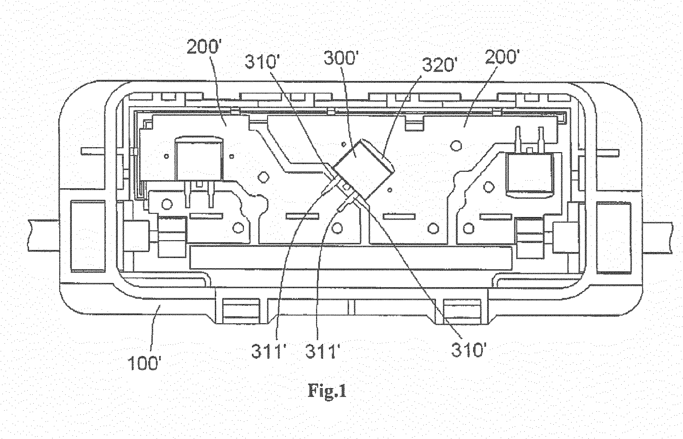

Solar panel (or solar cell panel) is generally adapted to collect solar energy and transform the collected solar energy to electrical energy. Fig.1 shows a perspective schematic view of a current photovoltaic junction box.

As shown in Fig.1, in the prior art, the photovoltaic junction box mainly comprises a housing 100', four contacts 200' provided in the housing 100' and three diodes 300'. Each diode 300' is mounted on two adjacent contacts 200'.

As shown in Fig.1, in the prior art, each diode 300' has a pair of separated anode pins 310', 310' and a cathode pin 320'. The pair of separated anode pins 310', 310' of each diode 300' are soldered on one of the two adjacent contacts 200', and the cathode pin 320' of each diode 300' is soldered on the other of the two adjacent contacts 200'.

As shown in Fig.1, in the prior art, each of the anode pins 310' has a soldering end portion 311' adapted to be soldered on the contact 200', however, the area of the soldering surfaces of the soldering end portions 311', 311' of the pair of anode pins 310', 310' of each diode 300' is relatively small, thereby causing that the soldering holding force between the anode pins 310', 310' of the diode 300' and the contact 200' is relatively weak. During the actual use, the anode pins 310', 310' of the diode 300' is prone to be damaged, thereby reducing the soldering stability of the anode pins.

Further, in the prior art, since the area of the soldering surfaces of the soldering end portions 311', 311' of the pair of anode pins 310', 310' of each diode 300' is relatively small, the current-carrying capacity of the pair of anode pins 310', 310' is reduced.

In WO 2006/067907 A1, a terminal box for solar cell modules is disclosed. It comprises four contact plates provided in a housing. The bare chip diodes are mounted on one of two adjacent contacts. The bare chip diodes are connected to a single electrode pin with a hole for soldering the electrode pin on the other of the two adjacent contacts. In order to position the electrode, a part of the contact has to be cut and lifted, creating a protrusion that can penetrate the hole of the electrode pin.

In patent US 2012/0052719 A1, a photovoltaic junction box, comprising a case and a lid covering the case and a plurality of terminals received within the case, is disclosed. Diodes are disposed between two adjacent terminals having a pair of first electrode pins soldered to the surface of one terminal and legs extending horizontally from the diode to be soldered to the other of the two adjacent terminals.

A diode lead frame for a solar module assembly is disclosed in US 2011/0121441 A1. It exhibits a lead frame design for a diode or other semiconductor devices that reduces stress on the device and provides increased heat dissipation. It comprises a bare chipped diode that has a first electrode pin and a second electrode pin provided at the top and at the bottom of the diode. The first and second electrode pin can be attached via a solder joint to a device and work, for example, as the bypass diode for one or more solar cells in a solar module.

### SUMMARY OF THE INVENTION

The object of the present disclosure is to solve the above mentioned technical problems or other technical problems of the prior art.

One object of the present disclosure is to provide a photovoltaic junction box, which may increase the soldering holding force between the first electrode pins of the diode and the contact and thus improve the current-carrying capacity and soldering stability of the first electrode pins.

According to one aspect of the present disclosure, there is provided a photovoltaic junction box, comprising: a housing; at least two contacts provided in the housing; and at least one diode each mounted on two adjacent contacts. Each diode comprises a pair of first electrode pins separated from each other and each having a soldering end portion adapted to be soldered on one of the two adjacent contacts, and a connection piece for connecting the soldering end portions of the pair of first electrode pins. The connection piece is configured to be soldered on the one of the two adjacent contacts along with the soldering end portions of the pair of first electrode pins.

According to an exemplary embodiment of the present disclosure, each diode further comprises a second electrode pin having an opposite polarity to that of the pair of first electrode pins, the second electrode pin being soldered on the other of the two adjacent contacts.

According to another exemplary embodiment of the present disclosure, each diode is a Surface-Mount diode adapted to be mounted on a surface of the contact by means of Surface Mount Technology.

According to another exemplary embodiment of the present disclosure, the connection piece has a first soldering surface adapted to be soldered on the surface of the one of the two adjacent contacts; the pair of first electrode pins of the diode have a second soldering surface adapted to be soldered on the surface of the one contact; and an area of the first soldering surface of the diode is larger than that of the second soldering surface.

According to another exemplary embodiment of the present disclosure, the area of the first soldering surface of the diode is 2 to 20 times the area of the second soldering surface.

According to another exemplary embodiment of the present disclosure, the area of the first soldering surface of the diode is 5 to 10 times the area of the second soldering surface.

According to another exemplary embodiment of the present disclosure, the second electrode pin of the diode has a third soldering surface adapted to be soldered on the surface of the other of the two adjacent contacts; and an area of the third soldering surface of the diode is larger than that of the second soldering surface.

According to another exemplary embodiment of the present disclosure, the pair of first electrode pins of the diode project outwards from a side portion of a packaging body of the diode and are electrically connected to a first electrode surface of a chip of the diode; and the second electrode pin of the diode is provided at a bottom of the packaging body of the diode and is electrically connected to a second electrode surface having the polarity opposite to that of the first electrode surface of the chip of the diode.

According to another exemplary embodiment of the present disclosure, the second electrode pin of the diode is a single soldering pad having a flat bottom surface adapted to be soldered on the surface of the other contact.

According to another exemplary embodiment of the present disclosure, each of the first electrode pins of the diode is a substantially strip-shaped soldering line.

According to another exemplary embodiment of the present disclosure, the pair of first electrode pins of each diode and the connection piece between the pair of first electrode pins form a single part from a single plate.

According to another exemplary embodiment of the present disclosure, the first electrode pin is an anode pin or a cathode pin of the diode.

According to another aspect of the present disclosure, there is provided a diode, comprising: a diode chip having a first electrode surface and a second electrode surface having a polarity opposite to that of the first electrode surface; a packaging body packaged on the diode chip; a pair of first electrode pins separated from each other and projecting outwards from a side portion of the packaging body and electrically connected to the first electrode surface of the diode chip; and a second electrode pin provided at a bottom of the packaging body and electrically connected to the second electrode surface of the diode chip. Each of the first electrode pins has a soldering end portion adapted to be soldered on a contact; and the diode further comprises a connection piece for connecting the soldering end portions of the pair of first electrode pins, and the connection piece is configured to be soldered on the contact along with the soldering end portions of the pair of first electrode pins.

According the previous embodiments of the present disclosure, the pair of first electrode pins of the diode are connected by a connecting piece, and the connecting piece along with the pair of first electrode pins are soldered on the contact, so as to increase the soldering area of the first electrode pins of the diode, thereby increasing the soldering holding force between the first electrode pins of the diode and the contact and in turn improving the current-carrying capacity and soldering stability of the first electrode pins.

### BRIEF DESCRIPTION OF THE DRAWINGS

The above and other features of the present disclosure will become more apparent by describing in detail exemplary embodiments thereof with reference to the accompanying drawings, in which:
Fig.1 shows a schematic perspective view of a current photovoltaic junction box;
Fig. 2 shows a schematic perspective view of a photovoltaic junction box according to an exemplary embodiment of the present disclosure;
Fig.3 shows an arrangement view of contacts and diodes in the photovoltaic junction box as shown in Fig.2; and
Fig.4 shows a cross-section view of the diode as shown in Fig.3.

### DETAILED DESCRIPTION OF PREFERRED EMBODIMENTS OF THE IVENTION

Technical solutions of the present disclosure will be described hereinafter in detail with reference to the attached drawings and in combination with the embodiments, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

Furthermore, in the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general technical concept of the invention, there is provided a photovoltaic junction box, comprising: a housing; at least two contacts provided in the housing; and at least one diode each mounted on two adjacent contacts. Each diode comprises a pair of first electrode pins separated from each other and each having a soldering end portion adapted to be soldered on one of the two adjacent contacts; each diode further comprises a connection piece for connecting the soldering end portions of the pair of first electrode pins, and the connection piece is configured to be soldered on the one of the two adjacent contacts along with the soldering end portions of the pair of first electrode pins.

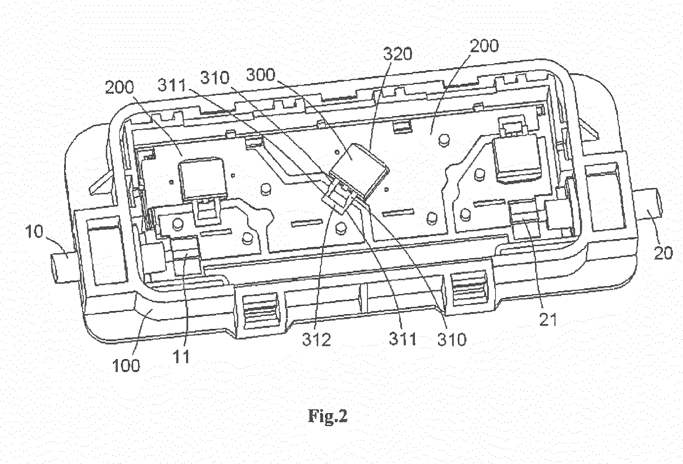

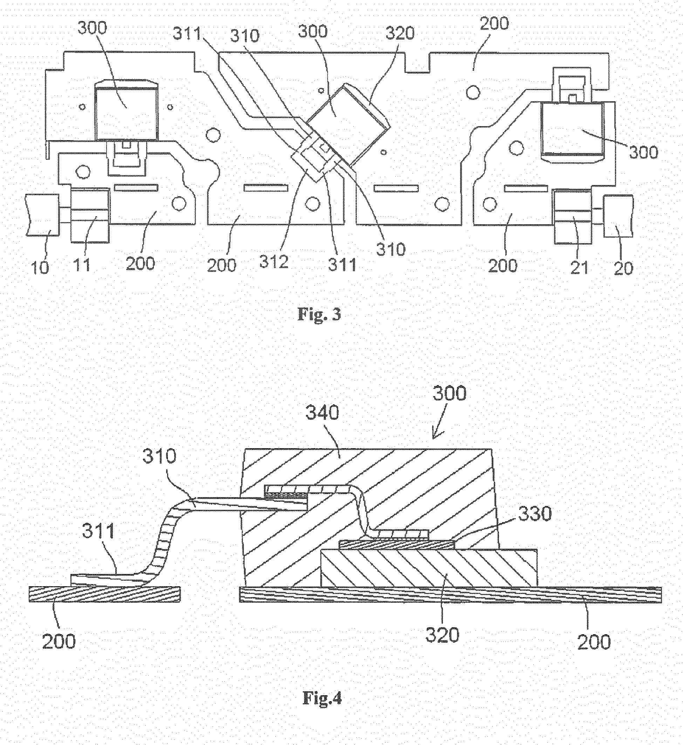

Fig. 2 shows a schematic perspective view of a photovoltaic junction box according to an exemplary embodiment of the present disclosure; and Fig.3 shows an arrangement view of contacts 200 and diodes 300 in the photovoltaic junction box as shown in Fig.2.

In an exemplary embodiment of the present disclosure, there is disclosed a photovoltaic junction box adapted to be mounted on the solar panel. As shown in Figs. 2 and 3, in the illustrated embodiment, the photovoltaic junction box mainly comprises a housing 100, at least two contacts 200 and at least one diode 300.

As shown in Figs. 2 and 3, in the illustrated embodiment, the contacts 200 are provided in the housing 100. Each diode 300 is mounted on two adjacent contacts 200, 200.

As shown in Figs. 2 and 3, in the illustrated embodiment, each diode 300 comprises a pair of first electrode pins 310, 310 separated from each other and a second electrode pin 320 having an opposite polarity to that of the first electrode pins. The pair of first electrode pins 310, 310 of each diode 300 are soldered on one of the two adjacent contacts 200, 200, and the second electrode pin 320 of each diode 300 is soldered on the other of the two adjacent contacts 200, 200.

As shown in Figs. 2 and 3, in the illustrated embodiment, each first electrode pin 310 has a soldering end portion 311 adapted to be soldered on the contact 200.

In an exemplary embodiment of the present disclosure, the first electrode pin 310 is acted as an anode pin or a cathode pin of the diode 300.

In an exemplary embodiment of the present disclosure, each diode 300 further comprises a connection piece 312 for connecting the soldering end portions 311, 311 of the pair of first electrode pins 310, 310, and the connection piece 312 is configured to be soldered on the contact 200 along with the soldering end portions 311, 311 of the pair of first electrode pins 310, 310 so as to increase the soldering area of the first electrode pins of the diode, thereby increasing the soldering holding force between the first electrode pins of the diode and the contact and in turn improving the current-carrying capacity and soldering stability of the first electrode pins.

In an exemplary embodiment of the present disclosure, as shown in Figs. 2 and 3, the pair of first electrode pins 310, 310 of each diode 300 and the connection piece 312 between the pair of first electrode pins 310, 310 are formed as a single part from a single plate.

As shown in Figs. 2 and 3, in the illustrated embodiment, each diode 300 is a Surface-Mount diode adapted to be mounted on a surface of the contact 200 by means of Surface Mount Technology.

In an exemplary embodiment of the present disclosure, as shown in Figs. 2 and 3, the connection piece 312 of the diode 300 has a first soldering surface adapted to be soldered on the surface of one of the two adjacent contacts 200, 200; the pair of first electrode pins 310, 310 of the diode 300 have a second soldering surface adapted to be soldered on the surface of the one of the two adjacent contacts 200, 200; and an area of the first soldering surface of the diode 300 is larger than that of the second soldering surface of the diode 300.

In an exemplary embodiment of the present disclosure, as shown in Figs. 2 and 3, the area of the first soldering surface of the diode 300 is 2 to 20 times the area of the second soldering surface of the diode 300.

In another exemplary embodiment of the present disclosure, as shown in Figs. 2 and 3, the area of the first soldering surface of the diode 300 is 5 to 10 times the area of the second soldering surface of the diode 300.

In another exemplary embodiment of the present disclosure, as shown in Figs. 2 and 3, the second electrode pin 320 of the diode 300 has a third soldering surface adapted to be soldered on the surface of the other of the two adjacent contacts 200, 200; and an area of the third soldering surface of the diode 300 is larger than that of the second soldering surface. In this way, the heat generated by a chip 330 (see Fig.4) of the diode 300 in operation may be transferred rapidly to the other of the two adjacent contacts 200, 200 by the second electrode pin 320 having a relatively large area, thereby improving the heat dissipation performance of the photovoltaic junction box.

Fig.4 shows a cross-section view of the diode as shown in Fig.3.

In another exemplary embodiment of the present disclosure, as shown in Figs. 2, 3 and 4, the pair of first electrode pins 310, 310 of the diode 300 project outwards from a side portion of a packaging body 340 of the diode300 and are electrically connected to a first electrode surface of the chip 330 of the diode 300; and the second electrode pin 320 of the diode 300 is provided at a bottom of the packaging body 340 of the diode 300 and is electrically connected to a second electrode surface having the polarity opposite to that of the first electrode surface of the chip 330 of the diode.

As shown in Figs. 2 and 3, in the illustrated embodiment, the second electrode pin 320 of the diode 300 is formed as a single soldering pad having a flat bottom surface adapted to be soldered on the surface of the other of the two adjacent contacts 200, 200.

As shown in Figs. 2 and 3, in the illustrated embodiment, each of the first electrode pins 310, 310 of the diode 300 is formed as a substantially strip-shaped soldering line.

In another exemplary embodiment of the present disclosure, there is also provided a diode 300. As shown in Figs. 2, 3 and 4, the diode 300 mainly comprises: a diode chip 330 having a first electrode surface and a second electrode surface having a polarity opposite to that of the first electrode surface; a packaging body 340 packaged on the diode chip 330; a pair of first electrode pins 310, 310 separated from each other and projecting outwards from a side portion of the packaging body 340 and electrically connected to the first electrode surface of the diode chip 330; and a second electrode pin 320 provided at a bottom of the packaging body 340 and electrically connected to the second electrode surface of the diode chip 330. Each of the first electrode pins 310, 310 has a soldering end portion 311 adapted to be soldered on a contact 200. As shown in Figs. 2 and 3, the diode 300 further comprises a connection piece 312 for connecting the soldering end portions 311, 311 of the pair of first electrode pins 310, 310, and the connection piece 312 is configured to be soldered on the contact 200 along with the soldering end portions 311, 311 of the pair of first electrode pins 310, 310 so as to increase the soldering area of the first electrode pins of the diode, thereby increasing the soldering holding force between the first electrode pins of the diode and the contact and thus improving the current-carrying capacity and soldering stability of the first electrode pins.

As shown in Figs. 2 and 3, in the illustrated embodiment, the photovoltaic junction box comprises four contacts 200, and three diodes 300. A conductor 11 of a first wire 10 directed into the housing 100 is soldered on the leftmost contact 200, and a conductor 21 of a second wire 20 directed into the housing 100 is soldered on the rightmost contact 200. Each diode 300 is soldered on two adjacent contacts 200.

Although the present disclosure has been described with reference to the attached drawings, the embodiments disclosed in the attached drawings are intended to describe the preferred embodiments of the present disclosure exemplarily, but should not be construed as a limitation to the present disclosure.

Although several embodiments of the general concept of the present disclosure have been shown and described, it would be appreciated by those skilled in the art that various changes or modifications may be made in these embodiments without departing from the principles of the disclosure, the scope of which is defined in the claims.

As used herein, term "comprising" or "having" should be understood as not excluding other elements or steps, and term "a" or "an" should be understood as not excluding plural elements or steps. In addition, any reference numeral in claims should not be understood as the limitation of the scope of the present disclosure.

## Claims

1. A photovoltaic junction box, comprising:
a housing (100);
at least two contacts (200) provided in the housing (100); and
at least one diode (300) each mounted on two adjacent contacts (200),
wherein each diode (300) comprises:
a pair of first electrode pins (310) separated from each other and each having a soldering end portion (311) adapted to be soldered on one of the two adjacent contacts (200); and
a connection piece (312) connected to the soldering end portions (311) of the pair of first electrode pins (310), and soldered on the one of the two adjacent contacts (200) along with the soldering end portions (211) of the pair of first electrode pins (310).

2. The photovoltaic junction box according to claim 1, wherein
each diode (300) further comprises a second electrode pin (320) having an opposite polarity to that of the pair of first electrode pins (310), the second electrode pin (320) being soldered on the other of the two adjacent contacts (200).

3. The photovoltaic junction box according to claim 1, wherein
each diode (300) comprises a Surface-Mount diode adapted to be mounted on a surface of the contact (200) by means of Surface Mount Technology.

4. The photovoltaic junction box according to claim 1, wherein
the connection piece (312) has a first soldering surface adapted to be soldered on the surface of the one of the two adjacent contacts (200);
the pair of first electrode pins (310) of the diode (300) have a second soldering surface adapted to be soldered on the surface of the one contact (200); and
an area of the first soldering surface of the diode (300) is larger than that of the second soldering surface.

5. The photovoltaic junction box according to claim 4, wherein
the area of the first soldering surface of the diode (300) is 2 to 20 times the area of the second soldering surface.

6. The photovoltaic junction box according to claim 5, wherein
the area of the first soldering surface of the diode (300) is 5 to 10 times the area of the second soldering surface.

7. The photovoltaic junction box according to claim 4, wherein
the second electrode pin (320) of the diode (300) has a third soldering surface adapted to be soldered on the surface of the other of the two adjacent contacts (200); and
an area of the third soldering surface of the diode (300) is larger than that of the second soldering surface.

8. The photovoltaic junction box according to claim 2, wherein
the pair of first electrode pins (310) of the diode (300) project outwards from a side portion of a packaging body (340) of the diode and are electrically connected to a first electrode surface of a chip (330) of the diode (300); and
the second electrode pin (320) of the diode (300) is provided at a bottom of the packaging body (340) of the diode (300) and is electrically connected to a second electrode surface having the polarity opposite to that of the first electrode surface of the chip (330) of the diode (300).

9. The photovoltaic junction box according to claim 8, wherein
the second electrode pin (320) of the diode (300) is formed as a single soldering pad having a flat bottom surface adapted to be soldered on the surface of the other contact.

10. The photovoltaic junction box according to claim 9, wherein
each of the first electrode pins (310) of the diode (300) is formed as a substantially strip-shaped soldering line.

11. The photovoltaic junction box according to claim 1, wherein
the pair of first electrode pins (310) of each diode (300) and the connection piece (312) between the pair of first electrode pins (310) are formed as a single part from a single plate.

12. The photovoltaic junction box according to claim 1, wherein
the first electrode pin (310) is acted as an anode pin or a cathode pin of the diode (300).

13. A diode (300), comprising:
a diode chip (330) having a first electrode surface and a second electrode surface having a polarity opposite to that of the first electrode surface;
a packaging body (340) packaged on the diode chip (330);
a pair of first electrode pins (310) separated from each other and projecting outwards from a side portion of the packaging body (340) and electrically connected to the first electrode surface of the diode chip (330); and
a second electrode pin (320) provided at a bottom of the packaging body (340) and electrically connected to the second electrode surface of the diode chip (330),
wherein each of the first electrode pins (310) has a soldering end portion (311) adapted to be soldered on a contact (200); and
wherein, the diode (300) further comprises a connection piece (312) for connecting the soldering end portions (311) of the pair of first electrode pins (310), and the connection piece (312) is configured to be soldered on the contact (200) along with the soldering end portions (311) of the pair of first electrode pins (310).

## Patentansprüche

1. Photovoltaik-Anschlusskasten, der umfasst:
ein Gehäuse (100);
wenigstens zwei Kontakte (200), die sich in dem Gehäuse (100) befinden; sowie
wenigstens eine Diode (300), die jeweils an zwei benachbarten Kontakten (200) montiert ist,
wobei jede Diode (300) umfasst:
ein Paar erster Elektrodenstifte (310), die voneinander getrennt sind und jeweils einen Löt-Endabschnitt (311) aufweisen, der zum Anlöten an einem der zwei benachbarten Kontakte (200) eingerichtet ist; sowie
ein Verbindungsstück (312), das mit den Löt-Endabschnitten (311) des Paars erster Elektrodenstifte (310) verbunden ist und zusammen mit den Löt-Endabschnitten (211) des Paars erster Elektrodenstifte (310) an dem einen der zwei benachbarten Kontakte (200) angelötet ist.

2. Photovoltaik-Anschlusskasten nach Anspruch 1, wobei
jede Diode (300) des Weiteren einen zweiten Elektrodenstift (320) mit einer Polarität umfasst, die entgegengesetzt zu der des Paars erster Elektrodenstifte (310) ist, und der zweite Elektrodenstift (320) an dem anderen der zwei benachbarten Kontakte (200) angelötet ist.

3. Photovoltaik-Anschlusskasten nach Anspruch 1, wobei
jede Diode (300) eine Oberflächenmontage-Diode umfasst, die so eingerichtet ist, dass sie mittels Oberflächenmontage-Technik an einer Oberfläche des Kontakts (200) montiert wird.

4. Photovoltaik-Anschlusskasten nach Anspruch 1, wobei
das Verbindungsstück (312) eine erste Lötfläche aufweist, die zum Anlöten an der Oberfläche des einen der zwei benachbarten Kontakte (200) eingerichtet ist;
das Paar erster Elektrodenstifte (310) der Diode (300) eine zweite Lötfläche aufweist, die zum Anlöten an der Oberfläche des einen Kontakts (200) eingerichtet ist; und
eine Flächenausdehnung der ersten Lötfläche der Diode (300) größer ist als die der zweiten Lötfläche.

5. Photovoltaik-Anschlusskasten nach Anspruch 4, wobei
die Flächenausdehnung der ersten Lötfläche der Diode (300) 2- bis 20-mal so groß ist wie die Flächenausdehnung der zweiten Lötfläche.

6. Photovoltaik-Anschlusskasten nach Anspruch 5, wobei
die Flächenausdehnung der ersten Lötfläche der Diode (300) 5- bis 10-mal so groß ist wie die Flächenausdehnung der zweiten Lötfläche.

7. Photovoltaik-Anschlusskasten nach Anspruch 4, wobei
der zweite Elektrodenstift (320) der Diode (300) eine dritte Lötfläche aufweist, die zum Anlöten an der Oberfläche des anderen der zwei benachbarten Kontakte (200) eingerichtet ist; und
eine Flächenausdehnung der dritten Lötfläche der Diode (300) größer ist als die der zweiten Lötfläche.

8. Photovoltaik-Anschlusskasten nach Anspruch 2, wobei
die paarigen ersten Elektrodenstifte (310) der Diode (300) von einem Seitenabschnitt eines Kapselungs-Körpers (340) der Diode nach außen vorstehen und elektrisch mit einer ersten Elektrodenfläche eines Chips (330) der Diode (300) verbunden sind; und
der zweite Elektrodenstift (320) der Diode (300) sich an einer Unterseite des Kapselungs-Körpers (340) der Diode (300) befindet und elektrisch mit einer zweiten Elektrodenfläche verbunden ist, deren Polarität entgegengesetzt zu der der ersten Elektrodenfläche des Chips (330) der Diode (300) ist.

9. Photovoltaik-Anschlusskasten nach Anspruch 8, wobei
der zweite Elektrodenstift (320) der Diode (300) als eine einzelne Lötstelle mit einer flachen Unterseite ausgebildet ist, die zum Anlöten an der Oberfläche des anderen Kontakts eingerichtet ist.

10. Photovoltaik-Anschlusskasten nach Anspruch 9, wobei
jeder der ersten Elektrodenstifte (310) der Diode (300) als eine im wesentlichen streifenförmige Lötlinie ausgebildet ist.

11. Photovoltaik-Anschlusskasten nach Anspruch 1, wobei
das Paar erster Elektrodenstifte (310) jeder Diode (300) und das Verbindungsstück (312) zwischen dem Paar erster Elektrodenstifte (310) als ein Teil aus einer Platte ausgebildet sind.

12. Photovoltaik-Anschlusskasten nach Anspruch 1, wobei
der erste Elektrodenstift (310) als ein Anoden-Stift oder ein Kathoden-Stift der Diode (300) fungiert.

13. Diode (300), die umfasst:
einen Dioden-Chip (330), der eine erste Elektrodenfläche und eine zweite Elektrodenfläche mit einer Polarität hat, die entgegengesetzt zu der der ersten Elektrodenfläche ist;
einen Kapselungs-Körper (340), der auf den Dioden-Chip (330) gekapselt ist;
ein Paar erster Elektrodenstifte (310), die voneinander getrennt sind, von einem Seitenabschnitt des Kapselungs-Körpers (340) nach außen vorstehen und elektrisch mit der ersten Elektrodenfläche des Dioden-Chips (330) verbunden sind; sowie
einen zweiten Elektrodenstift (320), der sich an einer Unterseite des Kapselungs-Körpers (340) befindet und elektrisch mit der zweiten Elektrodenfläche des Dioden-Chips (330) verbunden ist,
wobei jeder der ersten Elektrodenstifte (310) einen Löt-Endabschnitt (311) aufweist, der zum Anlöten an einem Kontakt (200) eingerichtet ist; und
die Diode (300) des Weiteren ein Verbindungsstück (312) zum Verbinden der Löt-Endabschnitte (311) des Paars erster Elektrodenstifte (310) umfasst und das Verbindungsstück (312) so eingerichtet ist, dass es zusammen mit den Löt-Endabschnitten (311) des Paars erster Elektrodenstifte (310) an dem Kontakt (200) angelötet wird.

## Revendications

1. Boîte de jonction photovoltaïque, comprenant :
un boîtier (100) ;
au moins deux contacts (200) agencés dans le boîtier (100) ; et
au moins une diode (300) chacune montée sur deux contacts adjacents (200),
dans laquelle chaque diode (300) comprend :
une paire de premières broches d'électrode (310) séparées l'une de l'autre et ayant chacune une partie d'extrémité de soudure (311) adaptée pour être soudée sur un premier des deux contacts adjacents (200) ; et
une pièce de connexion (312) connectée aux parties d'extrémité de soudure (311) de la paire de premières broches d'électrode (310), et soudée sur un premier des deux contacts adjacents (200) ensemble avec les parties d'extrémité de soudure (211) de la paire de premières broches d'électrode (310).

2. Boîte de jonction photovoltaïque selon la revendication 1, dans laquelle
chaque diode (300) comprend en outre une seconde broche d'électrode (320) ayant une polarité opposée à celle de la paire de premières broches d'électrode (310), la seconde broche d'électrode (320) étant soudée sur l'autre des deux contacts adjacents (200).

3. Boîte de jonction photovoltaïque selon la revendication 1, dans laquelle
chaque diode (300) comprend une diode à Montage en Surface adaptée pour être montée sur une surface du contact (200) au moyen d'une Technologie de Montage en Surface.

4. Boîte de jonction photovoltaïque selon la revendication 1, dans laquelle
la pièce de connexion (312) a une première surface de soudure adaptée pour être soudée sur la surface d'un premier des deux contacts adjacents (200) ;
la paire de premières broches d'électrode (310) de la diode (300) a une deuxième surface de soudure adaptée pour être soudée sur la surface du premier contact (200) ; et
une superficie de la première surface de soudure de la diode (300) est plus grande que celle de la deuxième surface de soudure.

5. Boîte de jonction photovoltaïque selon la revendication 4, dans laquelle
la superficie de la première surface de soudure de la diode (300) est de 2 à 20 fois la superficie de la deuxième surface de soudure.

6. Boîte de jonction photovoltaïque selon la revendication 5, dans laquelle
la superficie de la première surface de soudure de la diode (300) est de 5 à 10 fois la superficie de la deuxième surface de soudure.

7. Boîte de jonction photovoltaïque selon la revendication 4, dans laquelle
la seconde broche d'électrode (320) de la diode (300) a une troisième surface de soudure adaptée pour être soudée sur la surface de l'autre des deux contacts adjacents (200) ; et
une superficie de la troisième surface de soudure de la diode (300) est plus grande que celle de la deuxième surface de soudure.

8. Boîte de jonction photovoltaïque selon la revendication 2, dans laquelle
la paire de premières broches d'électrode (310) de la diode (300) fait saillie vers l'extérieur à partir d'une partie latérale d'un corps d'emballage (340) de la diode et sont connectées électriquement à une première surface d'électrode d'une puce (330) de la diode (300) ; et
la seconde broche d'électrode (320) de la diode (300) est agencée au fond du corps d'emballage (340) de la diode (300) et est connectée électriquement à une seconde surface d'électrode ayant la polarité opposée à celle de la première surface d'électrode de la puce (330) de la diode (300).

9. Boîte de jonction photovoltaïque selon la revendication 8, dans laquelle
la seconde broche d'électrode (320) de la diode (300) est formée sous forme d'une seule pastille de soudure ayant une surface inférieure plate adaptée pour être soudée sur la surface de l'autre contact.

10. Boîte de jonction photovoltaïque selon la revendication 9, dans laquelle
chacune des premières broches d'électrode (310) de la diode (300) est formée sous forme d'une ligne de soudure sensiblement en forme de bande.

11. Boîte de jonction photovoltaïque selon la revendication 1, dans laquelle
la paire de premières broches d'électrode (310) de chaque diode (300) et la pièce de connexion (312) entre la paire de premières broches d'électrode (310) sont formées sous forme d'une partie unique à partir d'une plaque unique.

12. Boîte de jonction photovoltaïque selon la revendication 1, dans laquelle
la première broche d'électrode (310) fonctionne comme une broche d'anode ou une broche de cathode de la diode (300).

13. Diode (300), comprenant :
une puce de diode (330) ayant une première surface d'électrode et une seconde surface d'électrode ayant une polarité opposée à celle de la première surface d'électrode ;
un corps d'emballage (340) emballé sur la puce de diode (330) ;
une paire de premières broches d'électrode (310) séparées l'une de l'autre et faisant saillie vers l'extérieur à partir d'une partie latérale du corps d'emballage (340) et connectées électriquement à la première surface d'électrode de la puce de diode (330) ; et
une seconde broche d'électrode (320) agencée au niveau d'un fond du corps d'emballage (340) et connectée électriquement à la seconde surface d'électrode de la puce de diode (330),
dans lequel chacune des premières broches d'électrode (310) a une partie d'extrémité de soudure (311) adaptée pour être soudée sur un contact (200) ; et
dans laquelle, la diode (300) comprend en outre une pièce de connexion (312) pour connecter les parties d'extrémité de soudure (311) de la paire de premières broches d'électrode (310), et la pièce de connexion (312) est configurée pour être soudée sur le contact (200) ensemble avec les parties d'extrémité de soudure (311) de la paire de premières broches d'électrode (310).
